(19) Europäisches Patentamt / European Patent Office / Office européen des brevets

(11) **EP 3 182 143 B1**

(12) **FASCICULE DE BREVET EUROPEEN**

(45) Date de publication et mention
de la délivrance du brevet:
**01.01.2020 Bulletin 2020/01**

(51) Int Cl.:
***G01R 15/18*** *(2006.01)*     ***H02H 1/00*** *(2006.01)*
***H02H 3/08*** *(2006.01)*

(21) Numéro de dépôt: **16199248.2**

(22) Date de dépôt: **17.11.2016**

(54) **CAPTEUR DE MESURE DE COURANT DE TYPE TORE DE ROGOWSKI, DISPOSITIF DE MESURE ET DE PROTECTION ET DISJONCTEUR ÉLECTRIQUE COMPORTANT UN TEL CAPTEUR**

ROGOWSKI-STROMSENSOR, SCHUTZ- UND MESSVORRICHTUNG, UND ELEKTRISCHER SCHUTZSCHALTER MIT SOLCHER MESSVORRICHTUNG

A SENSOR FOR MEASURING CURRENT OF THE ROGOWSKI-TORUS TYPE, PROTECTING AND MEASURING DEVICE AND ELECTRIC CIRCUIT BREAKER INCLUDING SUCH A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2015 FR 1562390**

(43) Date de publication de la demande:
**21.06.2017 Bulletin 2017/25**

(73) Titulaire: **Schneider Electric Industries SAS
92500 Rueil-Malmaison (FR)**

(72) Inventeurs:
• **LOGLISCI, David
38050 Grenoble Cedex 09 (FR)**
• **BUFFAT, Sébastien
3050 Grenoble Cedex 09 (FR)**
• **RAPEAUX, Michel
38050 Grenoble Cedex 09 (FR)**
• **SICARD, Stéphane
38050 Grenoble Cedex 09 (FR)**
• **ALBAN, Stéphane
38050 Grenoble Cedex 09 (FR)**

(74) Mandataire: **Tripodi, Paul
Schneider Electric Industries SAS
Service Propriété Industrielle
World Trade Center / 38EE1
5 Place Robert Schuman
38050 Grenoble Cedex 09 (FR)**

(56) Documents cités:
**US-A- 4 264 675**     **US-A- 5 982 265**
**US-A1- 2006 176 140**     **US-A1- 2008 007 249**
**US-A1- 2014 132 249**

**Description**

## DOMAINE TECHNIQUE

L'invention concerne un capteur de mesure de courant de type tore de Rogowski comportant un support en matériau amagnétique et un enroulement secondaire enroulé sur ledit support pour fournir un signal électrique représentatif d'un courant circulant dans un conducteur traversant l'intérieur du tore.

L'invention concerne aussi un dispositif de mesure et de protection électrique et un disjoncteur électrique comportant un tel capteur.

## ETAT DE LA TECHNIQUE

Les tores de Rogowski sont généralement connus dans le domaine des disjoncteurs de puissance équipés de déclencheurs électroniques. Ils sont utilisés pour la qualité de leur linéarité et grande dynamique de mesure puisqu'il ne comporte pas de circuit magnétique pouvant être saturé. Ainsi, la précision est directement liée à la régularité du bobinage et à la section du capteur.

Des exemples de capteurs à tores de Rogowski utilisés dans les disjoncteurs sont décrits dans les demandes de brevets EP2667205A1 et US2014132249A1. Le brevet US5982265 montre un autre capteur à tore de Rogowski à section ovale. D'autres tores comportant des rainures sont décrits dans les documents US2008/007249 et US2006/176140.

Le signal de sortie d'un tore de Rogowski est donné par la formule :

$$V = \mu_0\, n\, S\, di/dt$$

V étant la tension du signal de sortie fournie par le tore de Rogowski,
S la section d'une spire,
$\mu_0$ la perméabilité
n est le nombre de spires, et
di/dt la dérivée d'un courant primaire par rapport au temps.

Ainsi, la tension délivrée par le tore est fonction de la surface totale des spires et la précision de la tension est directement liée aux variations dimensionnelles du support des spires.

Selon les techniques de fabrication, les supports de bobinage des tores de Rogowski sont faits généralement avec des tubes en matière plastique souple ou par moulage d'une pièce plastique rigide.

Ces pièces plastiques rigides ont des formes stables et faciles à industrialiser en très grande série. Cependant, il est difficile d'atteindre une précision de mesure meilleure que 1% sans utiliser de système d'étalonnage.

D'autre part, dans les disjoncteurs il y a très peu de place disponible et la dynamique de température ambiante et très importante, par exemple de -40°C lors du démarrage du disjoncteur en milieu hostile tel que la haute montagne ou les zones arctiques jusqu'à 180°C pour un disjoncteur fonctionnant à courant nominal en environnement très chaud tel que zone équatoriale ou tropicale.

De telles variations génèrent des dilatations ou des changements de taille de la section du support qui a des répercutions sur la précision du signal de sortie.

De plus, lors de la fabrication le retrait pendant la phase de moulage est difficile à maitriser avec un support plein ou un support creux. Ceci contribue aussi à altérer la mesure dès lors qu'une grande précision est recherchée pour des tores fabriqués en série.

## EXPOSE DE L'INVENTION

L'invention a pour but un capteur à tore de Rogowski très précis pouvant être fabriqué en série et étant peu sensible aux variations de température, ainsi qu'un dispositif de protection et un disjoncteur comportant un tel capteur.

Selon l'invention, dans un capteur de mesure de courant de type tore de Rogowski comportant un support en matériaux amagnétique et un enroulement secondaire enroulé dur ledit support pour fournir un signal électrique représentatif d'un courant circulant dans un conducteur traversant l'intérieur du tore, ledit support est réalisé essentiellement en matière plastique rigide moulée et comporte au moins un évidement extérieur réparti sur la longueur ou la circonférence du corps du support, ledit évidement comportant au moins deux rainures séparées par une cloison.

De préférence, ledit support a une section ayant une forme de quadrilatère avec des angles arrondis, une face interne, une face externe, et deux faces latérales.

Avantageusement, au moins une des faces du support comporte ledit évidement comportant au moins deux rainures séparées par une cloison. En particulier, au moins une des deux faces latérales du support comporte au moins deux rainures séparées par une cloison. De préférence, les deux faces latérales du support comportent au moins deux rainures séparées par une cloison.

De préférence, ladite section du support de tore a une forme sensiblement trapézoïdale avec des angles arrondis. Avantageusement, la face interne et la face externe du support de forme trapézoïdale forment un angle droit plus ou moins 8 à 20 degrés par rapport aux faces latérales.

De préférence, le support comporte des renforts répartis le long des rainures pour maintenir la cloison.

Dans un mode de réalisation particulier, le support est constitué de résine amorphe avec une température de transition vitreuse supérieure à 200°C. De préférence, ladite résine est chargée par des billes ou des fibres de verre de taille inférieures à 200μm. De préférence, ladite résine est chargée entre 20 et 50%.

Un dispositif de mesure et de protection électrique pour disjoncteur comportant une unité de traitement pour recevoir des signaux représentatifs de courant électrique selon l'invention comporte un capteur de mesure tel que défini ci-dessus connecté à l'unité de traitement pour fournir un signal de courant représentatif d'un courant circulant dans un conducteur électrique.

Un disjoncteur électrique selon l'invention comportant au moins un contact principal pour couper un courant dans un circuit électrique, un mécanisme de commande de l'ouverture dudit contact électrique et un dispositif de mesure et de protection fournissant un signal de commande audit mécanisme de commande comporte un capteur de mesure tel que défini ci-dessus connecté à une unité de traitement dudit dispositif de mesure et de protection.

## BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

- la figure 1 représente une vue en coupe d'un support de tore selon un premier mode de réalisation de l'invention ;
- la figure 2 représente une vue de dessus du support de la figure 1 selon une variante du premier mode de réalisation de l'invention ;
- la figure 3 représente une vue en coupe d'un support de tore selon second mode de réalisation de l'invention ;
- les figures 4 et 5 représentent des vues en perspective montrant le haut et le bas du support de la figure 3 selon le second mode de réalisation de l'invention ;
- la figure 6 représente un schéma d'un disjoncteur électrique comportant un capteur selon un mode de réalisation de l'invention.

## DESCRIPTION DETAILLEE DE MODES DE REALISATION

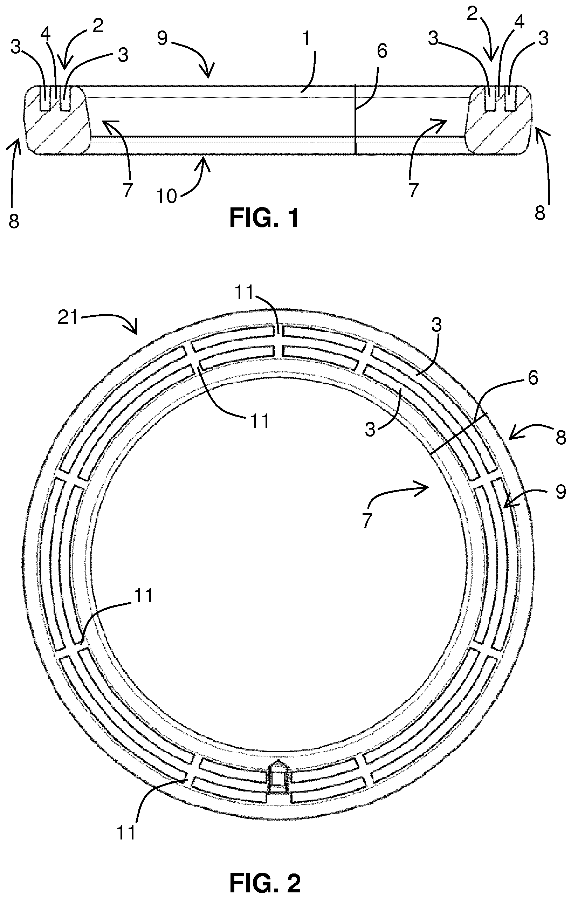

La figure 1 représente une vue en coupe d'un support 1 de tore selon un premier mode de réalisation de l'invention. Le support est en matériaux amagnétique tel que du plastique rigide moulée. Un enroulement secondaire 5 sera enroulé sur de support pour fournir un signal électrique de sortie du capteur de Rogowski. L'enroulement couvre toute la circonférence du support, cependant pour montrer la structure du support une seule spire 6 est représentée sur la figure 1. Ledit support 1 comporte au moins un évidement extérieur reparti sur la longueur ou la circonférence du corps du support. Ledit évidement 2 comporte au moins deux rainures 3 séparées par une cloison 4.

La hauteur de la cloison 4 participe à la définition de la section du support et évite que le fil de l'enroulement soit écrasé dans la rainure lors de la manipulation du tore. Lesdites rainures sont notamment des espaces vides servant à localiser le retrait de la matière plastique lors de l'opération de moulage dans une zone qui n'influe pas sur la section des spires. Ainsi, les rainures permettent d'éliminer l'effet de retrait du matériau plastique après le moulage. Avec cet évidement, les variations de dimension entre la phase de moulage et la phase produit fini sont très réduites.

La forme de la section peut être ovale, ronde mais préférentiellement avec quatre faces correspondant aux cotés d'un quadrilatère. Cette forme facilite la manipulation du tore par un opérateur lors du montage du capteur dans son boitier de protection et évite l'écrasement du fil du bobinage de l'enroulement secondaire. De préférence, les angles du quadrilatère sont arrondis pour faciliter le bobinage du fil sur le support.

La section du support ayant une forme de quadrilatère avec des angles arrondis, ledit support a une face interne 7, une face externe 8, et deux faces latérales 9 et 10 du capteur.

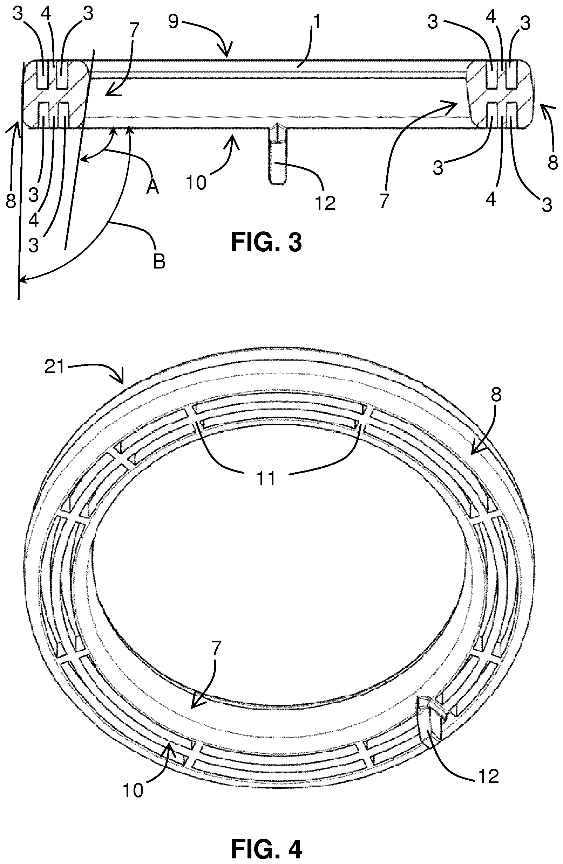

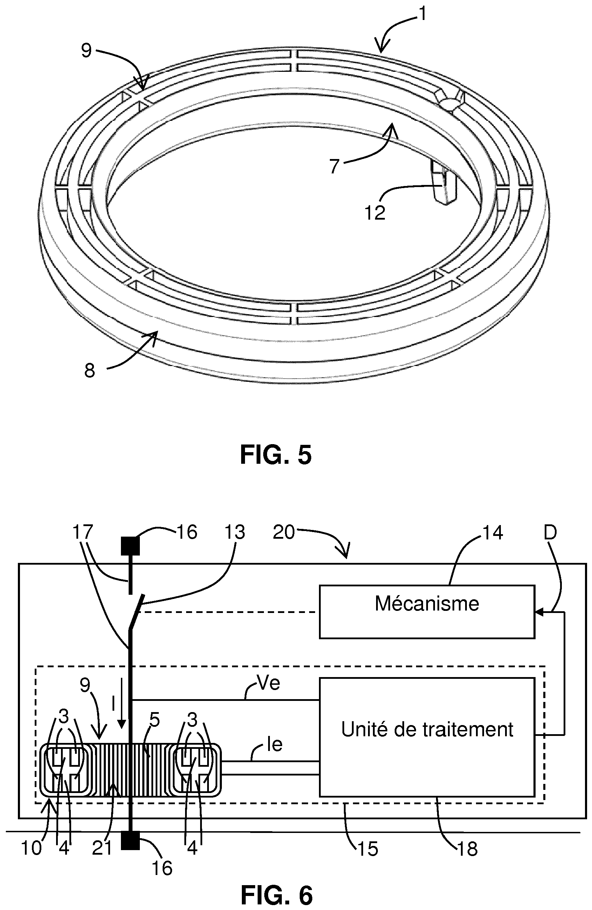

Dans le cas d'un support ayant une section en forme de quadrilatère, au moins une des faces du support du capteur comporte ledit évidement comportant au moins deux rainures 3 séparées par une cloison 4. De préférence, au moins une des deux faces latérales du support du capteur comporte au moins deux rainures séparées par une cloison. Sur les figures 1 et 2, les rainures sont sur la face latérale 9. Pour avoir des résultats encore plus précis, les deux faces latérales 9 et 10 du support du capteur comportent au moins deux rainures 3 séparées par une cloison 4. La figure 3 montre une vue en coupe d'un support de tore selon un second mode de réalisation de l'invention comportant des rainures sur les deux faces latérales 9 et 10. Les figures 4 et 5 représentent des vue en perspectives du support selon le second mode de réalisation de l'invention. Sur ces figures le support comporte aussi un plot 12 prévu pour maintenir les terminaisons de l'enroulement secondaire 5 lorsqu'il est enroulé sur le support 1.

Dans un cas particulier, ladite section du support 1 en forme de quadrilatère a une forme sensiblement trapézoïdale avec des angles arrondis. La forme trapézoïdale particulière permet d'optimiser la surface de la spire compte tenu de l'implantation du tore dans un disjoncteur. Les faces latérales 9 et 10 sont de préférence parallèles.

De préférence, la face interne et la face externe du support de forme trapézoïdale forment un angle A ou B droit de 90 degrés plus ou moins 8 à 20 degrés par rapport aux faces latérales 9 et 10. La section du support de tore de forme trapézoïdale avec un angle compris entre 5° et 20° permet d'obtenir la plus grande surface de spire possible compte tenu de contraintes mécaniques.

La vue de dessus du support représentée sur la figure 2 montre les deux rainures 3 et la cloison 4 présentes le long du support du tore sur une des faces latérales 9. Dans ce mode de réalisation, le support comporte des renforts 11 répartis le long des rainures 3 pour maintenir la cloison 4.

En plus de limiter le retrait de la matière par la forme du support et la présence de rainures externes sur le pourtour dudit support, un capteur selon l'invention a de préférence un support constitué par une résine amorphe avec une température de transition vitreuse (Tg) supérieure à 200°C. La caractéristique amorphe permet de réduire sensiblement le retrait au moulage et favorise un meilleur contrôle dimensionnel de la pièce moulée. Ainsi, un tel matériau, assure un coefficient de dilatation thermique linéaire CLTE (Coefficient of Linear Thermal Expansion en Anglais) constant et prédictible dans une gamme de température -40°C à 180°C. Le Coefficient de dilatation thermique linéaire CLTE étant très faible, proche de celui du cuivre, il est possible de garantir une grande précision de mesure ≤ 1% même en cas de variation thermique.

Avantageusement, ladite résine du support est chargée par des billes ou des fibres de verre de taille inférieure à 200µm. La charge ou le renfort de la matière permet de réduire le coefficient de dilatation thermique linéaire CLTE pour atteindre une valeur proche de celle du cuivre utilisé pour le bobinage de l'enroulement secondaire. Pour obtenir un facteur de forme proche de 1, les billes ou fibres de verre seront ultra-courtes de l'ordre de 50µm à 100µm. Elles permettront ainsi d'obtenir un coefficient de dilatation thermique linéaire CLTE quasi isotrope de la pièce quelque soit la direction. De préférence, ladite résine est chargée entre 20 et 50%, avec une préférence particulière autour de 30%.

La figure 6 représente un schéma d'un disjoncteur électrique 20 comportant un capteur 20 selon un mode de réalisation de l'invention associé à un dispositif de mesure et de protection. Le disjoncteur électrique 20 comporte au moins un contact principal 13 pour couper un courant I dans un circuit électrique, un mécanisme 14 de commande de l'ouverture dudit contact électrique 13 et un dispositif de mesure et de protection pour fournir un signal de commande D audit mécanisme 14 de commande. Le disjoncteur comporte aussi des bornes électriques 16 de puissance pour raccorder des conducteurs électriques externes et des conducteurs 17 de liaisons internes entre le contact principal 13 et les bornes 16. Au moins un capteur 21 de courant tel que décrit ci-dessus est disposé autour d'un conducteur primaire 17 du disjoncteur tel qu'un conducteur de liaison 17 entre une borne 16 et un contact principal 13. Le capteur de courant 21 est connecté à une unité de traitement 18 du dispositif 15 de mesure et de protection pour fournir des signaux représentatifs I-e d'un courant électrique circulant dans le conducteur primaire I. Ainsi, l'unité de traitement reçoit des signaux I-e représentatifs de courant électrique du capteur 21, effectue le traitement des signaux de courant, effectue les fonctions de protections et des signalisations et si besoin fourni un signal ou un ordre de déclenchement D au mécanisme 14 pour ouvrir les contacts 13 du disjoncteur.

Dans le disjoncteur de la figure 6, le capteur 21 a un support 1 selon le second mode de réalisation de l'invention avec des évidements sur les faces latérales 9 et 10. Chaque évidement comportant deux rainures 3 et une cloison 4. L'enroulement secondaire 5 est connecté à une entrée de l'unité de traitement 18 pour fournir le signal I-e de mesure de courant. L'unité de traitement peut aussi recevoir un signal de mesure de tension V-e depuis le conducteur primaire 17. Dans ce cas l'unité de traitement peut faire aussi le traitement et le calcul de l'énergie et/ou la puissance électrique avec une très grande précision.

Sur la figure 6 uniquement un disjoncteur à une phase ou pôle est représenté. Cependant, l'invention s'applique aussi à des disjoncteurs multipolaires notamment à des disjoncteurs triphasés. Dans ce cas, chaque pole protégé comporte un capteur de courant tel que défini ci-dessus.

Le dispositif de mesure et de protection 15 comportant le capteur 21 et l'unité de traitement 18, peut être un déclencheur électronique pour disjoncteur mais également un relais ou un module de protection et/ou de mesure de puissance et/ou d'énergie électrique.

**Revendications**

1. Capteur de mesure de courant de type tore de Rogowski comportant un support (1) en matériaux amagnétique et un enroulement secondaire (5) enroulé sur ledit support (1) pour fournir un signal électrique représentatif d'un courant circulant dans un conducteur traversant l'intérieur du tore, ledit support (1) étant réalisé essentiellement en matière plastique rigide moulée et comporte au moins un évidement (2, 3) extérieur reparti sur la longueur ou la circonférence du corps du support, ledit évidement (2) comportant au moins deux rainures (3) séparées par une cloison (4), **caractérisé en ce que** le support (1) est constitué de résine amorphe avec une température de transition vitreuse (Tg) supérieure à 200°C.

2. Capteur de mesure de courant selon la revendication 1 dans lequel ledit support (1) a une section ayant une forme de quadrilatère avec des angles arrondis, une face (7) interne, une face externe (8), et deux faces latérales (9, 10).

3. Capteur de mesure de courant selon la revendication 2 dans lequel au moins une des faces du support (1) comporte ledit évidement (2) comportant au moins deux rainures (3) séparées par une cloison (4).

**4.** Capteur de mesure de courant selon l'une des revendications 2 ou 3 dans lequel au moins une des deux faces latérales (9, 10) du support comporte au moins deux rainures (3) séparées par une cloison (4).

**5.** Capteur de mesure de courant selon l'une quelconque des revendications 2 à 4 dans lequel les deux faces latérales (9, 10) du support comportent au moins deux rainures (3) séparées par une cloison (4).

**6.** Capteur de mesure de courant selon l'une quelconque des revendications 2 à 5 dans lequel ladite section du support (1) de tore a une forme sensiblement trapézoïdale avec des angles arrondis.

**7.** Capteur de mesure de courant selon la revendication 6 dans lequel la face interne (7) et la face externe (8) du support de forme trapézoïdale forment un angle droit plus ou moins 8 à 20 degrés par rapport aux faces latérales (9, 10).

**8.** Capteur de mesure de courant selon l'une quelconque des revendications 1 à 7 dans lequel le support (1) comporte des renforts (11) répartis le long des rainures (3) pour maintenir la cloison (4).

**9.** Capteur de mesure de courant l'une quelconque des revendications 1 à 8 dans lequel ladite résine est chargée par des billes ou des fibres de verre de taille inférieures à 200μm.

**10.** Capteur de mesure de courant selon la revendication 8 dans lequel ladite résine est chargée entre 20 et 50%.

**11.** Dispositif (15) de mesure et de protection électrique pour disjoncteur comportant une unité de traitement (18) pour recevoir des signaux (I-e) représentatifs de courant électrique **caractérisé en ce qu'**il comporte un capteur de mesure (21) selon l'une quelconque des revendications 1 à 10 connecté à l'unité de traitement (18) pour fournir un signal (I-e) de courant représentatif d'un courant circulant dans un conducteur électrique.

**12.** Disjoncteur électrique (20) comportant au moins un contact principal (13) pour couper un courant dans un circuit électrique, un mécanisme (14) de commande de l'ouverture dudit contact électrique et un dispositif (15) de mesure et de protection fournissant un signal de commande (D) audit mécanisme de commande **caractérisée en ce qu'**il comporte un capteur (21) de mesure selon l'une quelconque des revendications 1 à 10 connecté à une unité de traitement dudit dispositif (18) de mesure et de protection.

**Patentansprüche**

**1.** Rogowski-Strommesssensor, umfassend einen Träger (1) aus nichtmagnetischen Materialien und eine Sekundärwicklung (5), die auf den Träger (1) gewickelt ist, um ein elektrisches Signal bereitzustellen, das für einen Strom repräsentativ ist, der in einem Leiter fließt, der durch das Innere des Ringkerns fließt, wobei der Träger (1) im Wesentlichen aus starrem, geformtem Kunststoffmaterial besteht und mindestens eine äußere Aussparung (2, 3), die über die Länge oder den Umfang des Körpers des Trägers verteilt ist, wobei die Aussparung (2) mindestens zwei Nuten (3) aufweist, die durch eine Trennwand (4) getrennt sind, **dadurch gekennzeichnet, dass** der Träger (1) aus amorphem Harz mit einer Glasübergangstemperatur (Tg) über 200° C besteht.

**2.** Strommesssensor nach Anspruch 1, wobei der Träger (1) einen Abschnitt mit einer vierseitigen Form mit abgerundeten Ecken, eine Innenfläche (7), eine Außenfläche (8) und zwei Seitenflächen (9, 10) aufweist.

**3.** Strommesssensor nach Anspruch 2, wobei mindestens eine der Flächen des Trägers (1) die Aussparung (2) mit mindestens zwei Nuten (3) aufweist, die durch eine Trennwand (4) getrennt sind.

**4.** Strommesssensor nach einem der Ansprüche 2 oder 3, bei dem mindestens eine der beiden Seitenflächen (9, 10) des Trägers mindestens zwei Nuten (3) aufweist, die durch eine Trennwand (4) getrennt sind.

**5.** Strommesssensor nach einem der Ansprüche 2 bis 4, bei dem die beiden Seitenflächen (9, 10) des Trägers mindestens zwei Nuten (3) aufweisen, die durch eine Trennwand (4) getrennt sind.

**6.** Strommesssensor nach einem der Ansprüche 2 bis 5, wobei der Abschnitt des Trägers (1) des Ringkerns eine im Wesentlichen trapezförmige Form mit abgerundeten Ecken aufweist.

**7.** Strommesssensor nach Anspruch 6, wobei die Innenseite (7) und die Außenseite (8) des trapezförmigen Trägers einen rechten Winkel von mehr oder weniger 8 bis 20 Grad in Bezug auf die Seitenflächen (9, 10) bilden.

**8.** Strommesssensor nach einem der Ansprüche 1 bis 7, wobei der Träger (1) Verstärkungen (11) aufweist, die entlang der Nuten (3) verteilt sind, um die Trennwand (4) aufzunehmen.

**9.** Strommesssensor nach einem der Ansprüche 1 bis 8, wobei das Harz durch Perlen oder Glasfasern mit einer Größe von weniger als 200 μm beladen wird.

**10.** Strommesssensor nach Anspruch 8, wobei das Harz zwischen 20 und 50 % beladen ist.

**11.** Elektrische Mess- und Schutzvorrichtung (15) für einen Leistungsschalter mit einer Verarbeitungseinheit (18) zum Empfangen von Signalen (I-e), die für den elektrischen Strom repräsentativ sind, **dadurch gekennzeichnet, dass** sie einen Strommesssensor (21) nach einem der Ansprüche 1 bis 10 umfasst, der mit der Verarbeitungseinheit (18) verbunden ist, um ein Stromsignal (I-e) bereitzustellen, das für einen in einem elektrischen Leiter fließenden Strom repräsentativ ist.

**12.** Elektrischer Leistungsschalter (20) mit mindestens einem Hauptkontakt (13) zum Abschalten eines Stroms in einem elektrischen Stromkreis, einem Mechanismus (14) zum Steuern des Öffnens des elektrischen Kontakts und einer Mess- und Schutzvorrichtung (15), die dem Steuermechanismus ein Steuersignal (D) liefert, **dadurch gekennzeichnet, dass** er einen Strommesssensor (21) nach einem der Ansprüche 1 bis 10 umfasst, der mit einer Verarbeitungseinheit der Mess- und Schutzvorrichtung (18) verbunden ist.

**Claims**

**1.** Current measurement sensor of the Rogowski-torus type including a carrier (1) made of amagnetic materials and a secondary winding (5) wound onto said carrier (1) so as to deliver an electrical signal that is representative of a current flowing through a conductor passing through the inside of the torus,
said carrier (1) being made primarily of a moulded rigid plastic material and includes at least one outer recess (2, 3) that is distributed along the length or around the circumference of the body of the carrier, said recess (2) including at least two grooves (3) that are separated by a partition (4),
**characterized in that** the carrier (1) is made of amorphous resin with a glass transition temperature (Tg) that is higher than 200°C.

**2.** Current measurement sensor according to Claim 1, wherein the cross section of said carrier (1) takes the shape of a quadrilateral with rounded corners, an inner face (7), an outer face (8) and two lateral faces (9, 10).

**3.** Current measurement sensor according to Claim 2, wherein at least one of the faces of the carrier (1) includes said recess (2) including at least two grooves (3) that are separated by a partition (4).

**4.** Current measurement sensor according to either of Claims 2 and 3, wherein at least one of the two lateral faces (9, 10) of the carrier includes at least two grooves (3) that are separated by a partition (4).

**5.** Current measurement sensor according to any one of Claims 2 to 4, wherein the two lateral faces (9, 10) of the carrier include at least two grooves (3) that are separated by a partition (4).

**6.** Measurement sensor according to any one of Claims 2 to 5, wherein said cross section of the torus carrier (1) substantially takes the shape of a trapezium with rounded corners.

**7.** Current measurement sensor according to Claim 6, wherein the inner face (7) and the outer face (8) of the trapezium-shaped carrier form a right angle plus or minus 8 to 20 degrees with respect to the lateral faces (9, 10).

**8.** Current measurement sensor according to any one of Claims 1 to 7, wherein the carrier (1) includes reinforcements (11) that are distributed along the grooves (3) so as to support the partition (4).

**9.** Current measurement sensor according to any one of Claims 1 to 8, wherein said resin is filled with glass fibres or beads that are smaller than 200 μm.

**10.** Current measurement sensor according to Claim 8, wherein said resin is between 20 and 50% filled.

**11.** Electrical protection and measurement device (15) for a circuit breaker including a processing unit (18) for receiving signals (I-e) that are representative of electric current, **characterized in that** it includes a measurement sensor (21) according to any one of Claims 1 to 10 that is connected to the processing unit (18) so as to deliver a current signal (I-e) that is representative of a current flowing through an electrical conductor.

**12.** Electrical circuit breaker (20) including at least one main contact (13) for interrupting a current through an electrical circuit, a mechanism (14) for controlling the opening of said electrical contact and a protection and measurement device (15) delivering a control signal (D) to said control mechanism, **characterized in that** it includes a measurement sensor (21) according to any one of Claims 1 to 10 that is connected to a processing unit (18) of said protection and measurement device.

**FIG. 1**

**FIG. 2**

**FIG. 3**

**FIG. 4**

**FIG. 5**

**FIG. 6**

## RÉFÉRENCES CITÉES DANS LA DESCRIPTION

**Documents brevets cités dans la description**

- EP 2667205 A1
- US 2014132249 A1
- US 5982265 A
- US 2008007249 A
- US 2006176140 A